# EUROPÄISCHE PATENTSCHRIFT

(11) **EP 0 394 768 B1**
(45) Veröffentlichungstag und Bekanntmachung des Hinweises auf die Patenterteilung: **01.03.1995**
(21) Anmeldenummer: 90107015.1
(22) Anmeldetag: 12.04.1990
(51) Int. Cl.: G01R 19/25

(54) **Verfahren und Anordnung zur Datenerfassung und -reduzierung bei Störwertermittlungen in Überwachungssystemen**
Method and device for data acquisition and compression for offnormal recording in monitoring systems
Procédé et dispositif d'acquisition et de compression de données dans des systèmes de surveillance lors de l'indication d'une valeur erronée

(30) Priorität: 27.04.1989 DE 3913975
(43) Veröffentlichungstag der Anmeldung: 31.10.1990
(73) Patentinhaber: SIEMENS AKTIENGESELLSCHAFT, 80333 München (DE)
(72) Erfinder: Kerner, Horst, D-8000 München 60 (DE)

(56) Entgegenhaltungen:
- DE-A- 3 612 234
- NACHRICHTENTECHNIK ELEKTRONIK Band 37, Nr. 1, 1987, Seiten10,11, Berlin, DE; H.-B. BEMMANN et al.: "Anwendung adaptiver Analog-Digital-Umsetzer in der Messtechnik"
- PATENT ABSTRACTS OF JAPAN Band 11, Nr. 201 (P-590)(2648), 30. Juni 1987; & JP - A - 6222075 (MITSUBISHI ELECTRIC) 30.01.1987

## Beschreibung

### Technisches Gebiet

Die Erfindung bezieht sich auf ein Verfahren und eine Anordnung gemäß den Merkmalen des Oberbegriffs des Anspruchs 1 und 4.

### Stand der Technik

Bei der Erfassung von Störvorgängen im Bereich der Überwachung von Phasenströmen und -spannungen, beispielsweise im Bereich der Elektrizitätsversorgung, werden die überwachten Signale erfaßt, digitalisiert, in einen Speicher abgelegt und zu einem späteren Zeitpunkt ausgewertet. Damit hochfrequente Komponenten der Störsignale ausreichend genau erfaßt werden, ist es erforderlich, die Signale mit einer hohen zeitlichen Auflösung zu erfassen.

Die Erfassung, Digitalisierung und Speicherung der überwachten Signale erfolgt zu fest vorgegebenen Zeitpunkten. Bedingt durch die vorhandenen Verarbeitungs- und Speicherungsmittel, muß ein Kompromiß geschlossen werden. Die Signale können mit einer relativ geringen Abtastrate erfaßt werden. Ein Mikroprozessor wertet diese Signale aus und nimmt eine Datenreduzierung mittels komplizierter und zeitintensiver Algorithmen vor. Der Nachteil dieses Verfahrens ist, daß eine zeitechte Verarbeitung nur dann möglich ist, wenn die Abtastrate gering verbleibt, bzw. daß eine zeitechte Erfassung und Datenreduzierung bei hoher Abtastrate, wie es erforderlich wäre, nicht möglich ist.

Aus der deutschen Patentanmeldung DE-A 36 12 234 ist es bekannt, die analoge Eingangsgröße eines solchen Datenerfassungssystems für die Überwachung von beispielsweise einer netzfrequenten Schwingung dadurch zu erfassen, daß sie zweimal differenziert wird, und sie nur bei den Nulldurchgängen der ersten und der zweiten Differentiation abgetastet wird. Es werden also die Minima und Maxima sowie die Wendepunkte erfaßt. Zur Rekonstruktion des analogen Signals werden diese Minima- und Maximawerte sowie die Werte der Wendepunkte mit Hilfe mathematischer Methoden zur Berechnung des analogen Signals ausgewertet.

In der Zeitschrift Nachrichtentechnik Elektronik", Band 37 (1987), No. 1, Seiten 10 und 11 ist eine Analog-Digital-Umsetzverfahren beschrieben, bei dem die Abtastrate in Abhängigkeit von der Geschwindigkeit der Signaländerung verändert wird. Bei langsamer Änderung des Signals wird mit hoher Genauigkeit und niedriger Abtastrate, bei rascher Änderung mit geringerer Genauigkeit und hoher Abtastrate abgetastet.

### Darstellung der Erfindung

Der Erfindung liegt die Aufgabe zugrunde, bei einem eingangs genannten Verfahren und einer Anordnung zur Durchführung dieses Verfahrens die auszuwertenden Daten zu reduzieren, ohne die Rekonstruktionsmöglichkeiten einzuschränken.

Zur Lösung dieser Aufgabe weist ein Verfahren der eingangs genannten Art die Merkmale des Kennzeichens des Anspruchs 1 auf. Vorteilhafte Ausführungsformen sind in den Unteransprüchen 2 und 3 angegeben. Mit einer Anordnung nach Anspruch 4 kann in vorteilhafter Weise das erfindungsgemäße Verfahren ausgeführt werden.

Dadurch, daß gemäß der Erfindung die Abtastung des analogen Signals abhängig von der Krümmung des Verlaufs der analogen Größe gemacht wird, kann in dem zur Rekonstruktion des analogen Signals angeordneten Hauptspeicher im Überwachungssystem eine optimale Ausnutzung der vorhandenen Speicherplätze ermöglicht werden. Insbesondere bei geringen Krümmungen der zu überwachenden analogen Größe ergeben sich einfache Rekonstruktionsmöglichkeiten, z. B. durch Linearisierung; es können somit ohne Verluste bei der Qualität der Rekonstruktion einige Abtastwerte eingespart werden. Im Bereich starker Krümmung, z. B. bei den oberen und unteren Krümmungen der Amplituden des analogen Signals, werden dagegen eine Vielzahl Abtastwerte der maximalen Abtastfrequenz abgespeichert.

### Kurze Beschreibung des Ausführungsbeispiels der Erfindung

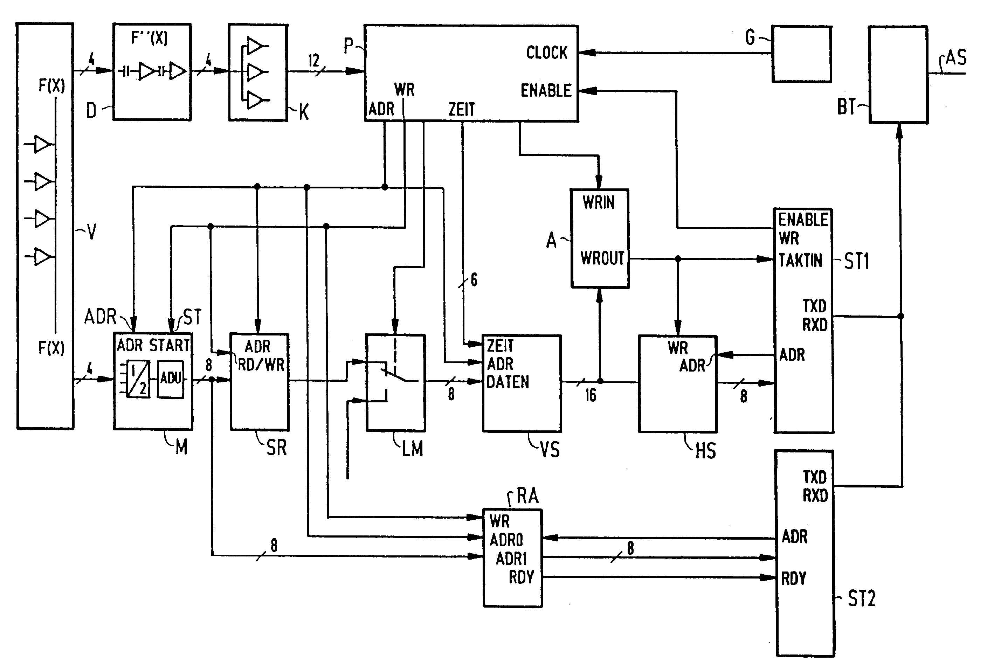

In der Figur ist ein Blockschaltbild für eine Analogeingabeschaltung eines Überwachungssystems dargestellt.

### Bester Weg zur Ausführung der Erfindung

In der Figur ist zunächst ein Wandler und Eingangsverstärker V für insgesamt vier Analogeingänge vorhanden, wobei diese vier Analogeingänge zusammen auf einen zweifachen Differenzierer D und einen Multiplexer M geführt sind. Das Ausgangssignal des Differenzierers D wird über einen Komparator K und einen Eingang einer Speichersteuerung P geführt, die das Ausgangssignal des Komparators K hinsichtlich der Krümmungen im zeitlichen Verlauf auswertet. Die Speichersteuerung P wird über einen Generator G mit einem Takt, z. B. 12,5 kHz, versorgt.

Das Ausgangssignal des Multiplexers M, der über einen Adreßeingang ADR und einen Starteingang ST von der Speichersteuerung P gesteuert wird, wird zunächst über ein Schieberegister SR, beispielsweise mit einem Speichervolumen von 4 x 8 Byte, auf eine Leerdatenmarkierung LM geführt. Auch die Leerdatenmarkierung LM wird von der Speichersteuerung P derart gesteuert, daß, abhängig vom Verlauf der Krümmung des analogen Signals, eine Leerdatenmarkierung nicht notwendiger Abtastpunkte vorgenommen wird oder nicht. Die so gekennzeichneten Daten werden über einen Vorgeschichtsspeicher VS in den Hauptspeicher HS geleitet, wobei in einer von der Speichersteuerung P gesteuerten Ausblendeschaltung A die Ausblendung der markierten Leerdaten vorgenommen wird. Über eine weitere Steuerschaltung ST1 können die Daten des Hauptspeichers über einen Bustreiber BT an eine Ausgangsschnittstelle AS gegeben werden. Weiterhin ist noch eine direkte Ausblendung der Ausgangsdaten des Multiplexers M über einen Register- und Adreßvergleicher RA und einen weiteren Steuerrechner T2 auf den Bustreiber BT möglich.

### Gewerbliche Anwendbarkeit

Die Erfindung ist vor allem bei der Störwertermittlung in Energieversorgungs- oder -übertragungsanlagen einsetzbar.

## Patentansprüche

1. Verfahren zur Datenerfassung und Reduzierung bei Störwertermittlungen in Überwachungssystemen, bei dem
- die überwachten Signale als analoge elektrische Größen abgetastet, digitalisiert, an definierten Stellen zweimalig differenziert und ausgewertet werden
**dadurch gekennzeichnet**, daß
- die elektrische Größe während ihres gesamten zeitlichen Verlaufs zweimalig differenziert wird und daß abgetastete Werte der elektrischen Größe nach Digitalisierung mit einer von der zweifach differenzierten Größe abhängigen Frequenz erfaßt werden.

2. Verfahren nach Anspruch 1, **dadurch gekennzeichnet, daß**
- in den Bereichen des zeitlichen Verlaufs der analogen Größe mit geringer Krümmung ein oder mehrere abgetastete werte nicht in einen zur Rekonstruktion der analogen Größe vorhandenen Hauptspeicher (HS) gelangen.

3. Verfahren nach Anspruch 2, **dadurch gekenn****zeichnet**, daß
- die nicht in den Hauptspeicher (HS) geführten abgetasteten Werte als Leerdaten markiert werden, wobei die jeweilige Vorgeschichte des Verlaufs der analogen Größe von einer Leerdatenmarkierung ausgewertet wird.

4. Anordnung zur Datenerfassung und Reduzierung bei Störwertermittlungen in Überwachungssystemen, mit einem zweifachen Differenzierer (D) und einer Abtastschaltung (M), denen eine analoge Größe zugeführt ist und mit einer Erfassungseinrichtung, die in Abhängigkeit des Ausgangssignals des Zweifachdifferenzierers (D) abgetastete Werte der analogen Größe erfaßt, **dadurch gekennzeichnet**, daß
die Ausgangssignale des Zweifachdifferenzierers (D) über einen Komparator (K) einer Speichersteuerung (P) zugeführt sind, die das Ausgangssignal des Komparators (K) hinsichtlich der Krümmungen im zeitlichen Verlauf der analogen Größe auswertet und eine Leerdatenmarkierung (LM) steuert, die einem als Abtastschaltung dienenden Multiplexer (M) nachgeschaltet ist und die in Abhängigkeit von der Krümmung des Verlaufs des analogen Signals abgetastete Werte als Leerdaten markiert, und daß an die Leerdatenmarkierung (LM) ein als Erfassungseinrichtung dienender Hauptspeicher (HS) zur Erfassung der analogen Größe angeschlossen ist sowie eine Ausblendschaltung (A), die als Leerdaten markierten Daten von dem Einschreiben in den Hauptspeicher (HS) ausblendet.

5. Anordnung nach Anspruch 4, dadurch **gekennzeich****net**, daß
zwischen die Leerdatenmarkierung (LM) und den Hauptspeicher (HS) ein Vorgeschichtsspeicher (VS) geschaltet ist.

## Claims

1. Method for data detection and reduction in determinations of faults in monitoring systems, where
- the monitored signals are sampled as analog electrical variables, digitized, differentiated twice at defined points and evaluated,
characterized in that
- the electrical variable during its entire temporal characteristic is differentiated twice and in that sampled values of the electrical variable are detected after digitization with a frequency dependent on the variable differentiated twice.

2. Method according to claim 1,
characterized in that
- in the regions of the temporal characteristic of the analog variable with little curvature one or more sampled values do not arrive in a main memory (HS) present for the reconstruction of the analog variable.

3. Method according to claim 2,
characterized in that
- the sampled values not guided into the main memory (HS) are marked as empty data, with the respective antecedent of the characteristic of the analog variable being evaluated by an empty data marking.

4. Arrangement for data detection and reduction in determinations of faults in monitoring systems, having a double differentiator (D) and a sampling circuit (M), to which there is supplied an analog variable, and having a detection device which detects in dependence upon the output signal of the double differentiator (D) sampled values of the analog variable, characterized in that the output signals of the double differentiator (D) are supplied by way of a comparator (K) to a memory control unit (P) which evaluates the output signal of the comparator (K) with respect to the curvatures in the temporal characteristic of the analog variable and controls an empty data marking (LM) which is connected downstream of a multiplexer (M) serving as sampling circuit and which marks in dependence upon the curvature of the characteristic of the analog signal sampled values as empty data, and in that there is connected to the empty data marking (LM) a main memory (HS) serving as detection device for the detection of the analog variable and a masking circuit (A) which masks the data marked as empty data from writing into the main memory (HS).

5. Arrangement according to claim 4, characterized in that an antecedent memory (VS) is connected between the empty data marking (LM) and the main memory (HS).

## Revendications

1. Procédé d'acquisition et de réduction de données lors de déterminations de valeurs perturbées dans des systèmes de contrôle, selon lequel
- les signaux contrôlés sont échantillonnés en tant que grandeurs électriques analogiques, sont numérisés, et sont différentiés et évalués deux fois en des emplacements définis,
caractérisé par le fait que
- pendant l'ensemble de la variation dans le temps de la grandeur analogique, la grandeur électrique est différentiée et que des valeurs échantillonnées de la grandeur électrique sont détectées, après numérisation, avec une fréquence qui dépend de la grandeur différentiée.

2. Procédé suivant la revendication 1, caractérisé par le fait que
- dans les parties de la courbe de variation dans le temps de la grandeur analogique, qui possèdent une faible courbure, une ou plusieurs valeurs échantillonnées ne parviennent pas dans une mémoire principale (HS) prévue pour la reconstitution de la grandeur analogique.

3. Procédé suivant la revendication 2, caractérisé par le fait que
- les valeurs échantillonnées, qui ne sont pas envoyées dans la mémoire principale (HS), sont marquées en tant que données vides, l'historique respectif de la variation de la grandeur analogique étant évalué par un marquage de données vides.

4. Dispositif d'acquisition et de réduction de données dans le cas de déterminations de valeurs perturbatrices dans des systèmes de contrôle, comportant un différentiateur double (D) et un circuit d'échantilonnage (M), auxquels est envoyée une grandeur analogique, et un dispositif d'acquisition qui détecte, en fonction du signal de sortie du différentiateur double (D), des valeurs échantillonnées de la grandeur analogique, caractérisé par le fait
que les signaux de sortie du différentiateur double (D) sont envoyés, par l'intermédiaire d'un comparateur (K), à l'unité de commande de mémoire (P), qui évalue le signal de sortie du comparateur (K) en ce qui concerne les courbures de la variation dans le temps de la grandeur analogique, et commande une unité (LM) de marquage des données vides, qui est branché en aval d'un multiplexeur (M) utilisé en tant que dispositif d'échantillonnage, et les valeurs, qui sont échantillonnées en fonction de la courbure de la variation du signal analogique, sont marquées en tant que données vides, et qu'à l'unité (LM) de marquage des données vides est raccordée une mémoire principale (H5) utilisée comme dispositif de détection pour détecter la grandeur analogique, ainsi qu'un circuit de suppression (A), qui supprime les données marquées comme étant des données vides, avant l'enregistrement dans la mémoire principale (HS).

5. Dispositif suivant la revendication 4, caractérisé par le fait qu'une mémoire d'historique (VS) est branchée entre l'unité (LM) de marquage des données vides et la mémoire principale (HS).
